# EUROPÄISCHE PATENTSCHRIFT

(11) **EP 3 502 726 B1**
(45) Veröffentlichungstag und Bekanntmachung des Hinweises auf die Patenterteilung: **07.06.2023**
(21) Anmeldenummer: 17209660.4
(22) Anmeldetag: 21.12.2017
(51) Int. Cl.: G01R 33/36

(54) **VERBESSERTE ERFASSUNG VON MAGNETRESONANZSIGNALEN**
IMPROVED DETECTION OF MAGNETIC RESONANCE SIGNALS
DÉTECTION AMÉLIORÉE DE SIGNAUX DE RÉSONANCE MAGNÉTIQUE

(43) Veröffentlichungstag der Anmeldung: 26.06.2019
(73) Patentinhaber: Siemens Healthcare GmbH, 91052 Erlangen (DE)
(72) Erfinder: Demharter, Nikolaus, 91077 Dormitz (DE)

(56) Entgegenhaltungen:
- WO-A1-2009/139287
- US-A1- 2009 174 498
- US-A1- 2010 271 022

## Beschreibung

Die Erfindung betrifft ein Verfahren zum Empfang von Magnetresonanzsignalen durch eine Magnetresonanzvorrichtung, eine entsprechende Magnetresonanzvorrichtung und ein entsprechendes Computerprogrammprodukt.

Die Magnetresonanztomographie (MRT; engl. Magnetic Resonance Imaging, MRI) ist eine bekannte Untersuchungstechnik zum Erzeugen von Abbildungen eines Körperinneren eines Patienten, die auf dem physikalischen Phänomen der Magnetresonanz (MR) beruht. Eine Magnetresonanzvorrichtung umfasst dazu in der Regel ein Sendesystem, mit dem hochfrequente (HF, engl. RF) elektromagnetische Anregungspulse, oft auch HF-Pulse genannt, erzeugt werden können, die bei einer Magnetresonanzmessung in den Patienten eingestrahlt werden. Die Druckschriften US 20140347054 A1, US 8901929 B2 und DE 10 2012 210 280 B4 zeigen exemplarisch verschiedene Ausführungsformen eines Sendesystems. Aus der HF-Einstrahlung resultiert ein magnetisches Wechselfeld mit einer Sendefrequenz, das auch B1-Feld genannt wird. Die eingestrahlten Anregungspulse sind in der Lage, Kernspins auszulenken, um eine gewünschte Flipwinkelverteilung für die jeweilige Untersuchung zu erhalten. Die ausgelenkten Kernspins geben wiederum Magnetresonanzsignale ab, die von einem oder mehreren Empfangsspulenelementen gemessen werden.

Unter einem Empfangsspulenelement kann insbesondere eine Antenne und/oder eine elektrisch leitfähige Schleife verstanden werden, die ausgebildet ist, Magnetresonanzsignale zu empfangen. Eine Magnetresonanzspule kann ein oder mehrere Empfangsspulenelemente umfassen. Magnetresonanzspulen können fest in die Magnetresonanzvorrichtung eingebaut werden, wie z.B. Ganzkörperspulen (engl. body coils) oder lokal am Patienten angeordnet werden, wie z.B. Lokalspulen (engl. local coils) bzw. Oberflächenspulen (engl. surface coils). Eine Exemplarisch sind eine Ganzkörperspule in US 20150054506 A1 und eine Lokalspule in US 20140159721 A1 beschrieben.

Jedes der Dokumente US 2010/0271022 A1, WO 2009/139287 A1 und US 2009/0174498 A1 offenbart ein MR-Gerät mit einem Multiplexer mit einem Signalausgang und mehreren Signaleingängen.

Durch Rekonstruktion der Magnetresonanzsignale können die Abbildungen des Körperinneren des Patienten erzeugt werden. Um aussagekräftige Abbildungen erhalten, ist es wichtig, zur Rekonstruktion Daten hoher Qualität zu verwenden. Ferner ist es erstrebenswert, die Messzeit zur Erfassung der Magnetresonanzsignale zu reduzieren. Als Aufgabe der vorliegenden Erfindung kann angesehen werden, verbesserte Daten für die Rekonstruktion zur Verfügung zu stellen und/oder die Zeit zur Erfassung der Daten zu verringern.

Die Aufgabe wird durch die Merkmale der unabhängigen Ansprüche gelöst. Vorteilhafte Ausgestaltungen sind in den Unteransprüchen beschrieben.

Demnach wird ein Verfahren gemäß Anspruch 1 zum Empfang von Magnetresonanzsignalen durch eine Magnetresonanzvorrichtung vorgeschlagen. Dabei umfasst die Magnetresonanzvorrichtung zumindest ein aktives Empfangsspulenelement, mit der Magnetresonanzsignale empfangen werden, und einen Multiplexer mit einem Signalausgang und mehreren Signaleingängen, wobei ein erstes aktives Empfangsspulenelement mit einem ersten Signaleingang und ein zweites aktives Empfangsspulenelement mit einem zweiten Signaleingang verbunden ist, wobei der Multiplexer eine Anzahl an Signaleingängen aufweist, die größer als die Anzahl der aktiven Empfangsspulenelemente ist. Dabei ist der restliche Teil der mehreren Signaleingänge mit keinem aktiven Empfangsspulenelement verbunden. Unter einer Verbindung zwischen einem aktiven Empfangsspulenelement mit einem Signaleingang kann jede Art von Kopplung, insbesondere eine elektrische und/oder optische Kopplung, verstanden werden, die eine Übertragung von Signalen zwischen dem aktiven Empfangsspulenelement und dem Signaleingang ermöglicht. Der Multiplexer schaltet während des Empfangs der Magnetresonanzsignale nacheinander die Signaleingänge, die mit jeweils einem aktiven Empfangsspulenelement verbunden sind, an den Signalausgang durch, wobei der Multiplexer zumindest einen Teil des restlichen Teils der mehreren Signaleingänge, der mit keinem aktiven Empfangsspulenelement verbunden ist, nicht an den Signalausgang durchschaltet.

Dadurch dass der Multiplexer zumindest einen Teil des restlichen Teils der mehreren Signaleingänge, der mit keinem aktiven Empfangsspulenelement verbunden ist, nicht an den Signalausgang durchschaltet, können mehr wertvolle Magnetresonanzsignale durch die Magnetresonanzvorrichtung aufgenommen werden, so dass sich die Datenbasis für die Rekonstruktion der MR-Abbildungen verbessert. Ferner kann die Erfassung der Magnetresonanzsignale beschleunigt werden, da nicht genutzte Messzeit besser vermieden wird. Dagegen werden herkömmliche Multiplexer derart betrieben, dass alle Signaleingänge durchgeschaltet werden, also auch alle Signaleingänge, die mit keinem aktiven Empfangsspulenelement verbunden sind. In den Zeiträumen, in denen Signaleingänge an den Signalausgang durchgeschaltet werden, die mit keinem aktiven Empfangsspulenelement verbunden sind, können keine nutzbaren Magnetresonanzsignale verarbeitet werden.

Ein Multiplexer kann als Schaltmatrix und/oder Selektionsschaltung mit mehreren Eingängen und üblicherweise einem Ausgang aufgefasst werden. Durch den oder gegebenenfalls mehrere Multiplexer kann üblicherweise eine Anzahl an Empfangsspulenelementen an die Magnetresonanzvorrichtung angeschlossen werden, die der Summe der Eingänge des Multiplexers bzw. der Multiplexer entspricht.

Der Multiplexer kann beispielsweise mittels einer Systemsteuereinheit der Magnetresonanzvorrichtung angesteuert werden. Dadurch kann die Betriebsweise, insbesondere die Schaltvorgänge, des Multiplexers kontrolliert werden.

Wie bereits angesprochen, kann die Magnetresonanzvorrichtung nicht nur einen, sondern weitere Multiplexer umfassen, die vorteilhafterweise jeweils ebenso zumindest einen Teil des restlichen Teils der mehreren Signaleingänge, der mit keinem aktiven Empfangsspulenelement verbunden ist, nicht an den Signalausgang durchschaltet. Die Erfindung kann also ohne weiteres auch auf eine Mehrzahl an Multiplexern übertragen werden.

Unter einem aktiven Empfangsspulenelement wird ein Antennenelement verstanden, das hochfrequente Magnetresonanzsignale empfangen kann. Ein aktives Empfangsspulenelement ist ein Empfangsspulenelement, das für die jeweilige Untersuchung zum Empfang der Magnetresonanzsignale vorgesehen ist. Ein aktives Empfangsspulenelement ist also ein Empfangsspulenelement, mit dem gewollt Magnetresonanzsignale empfangen werden. Damit unterscheidet sich ein aktives Antennenelement von etwaigen Antennenelementen, die zwar auch mit etwaigen Signaleingängen des Multiplexers verbunden sein können, die aber für eine jeweilige Untersuchung gar nicht verwendet werden sollen. Vorteilhafterweise wird in diesem Fall der Multiplexer so angesteuert, dass die etwaigen Signaleingänge, die mit nicht zum Empfang vorgesehenen Empfangsspulenelementen verbunden sind, nicht an den Signalausgang durchgeschaltet werden. Für eine solche Ansteuerung notwendige Informationen können in einer Systemsteuereinheit der Magnetresonanzvorrichtung abgelegt sein.

Vorzugsweise erkennt die Magnetresonanzvorrichtung, ob ein aktives Empfangsspulenelement an einem Signaleingang des Multiplexers angeschlossen ist, z.B. ob in einem Beispiel, das nicht in den Schutzumfang der Ansprüche fällt, eine Lokalspule mit einem oder mehreren aktiven Empfangsspulenelementen angeschlossen ist. Vorteilhafterweise wird die Information, ob ein aktives Empfangsspulenelement an einem Signaleingang des Multiplexers angeschlossen ist, an die Systemsteuereinheit übermittelt und/oder es werden automatisch die sinnvoll nutzbaren Signaleingänge an den Signalausgang durchgeschaltet.

Erfindungsgemäß können von einem Signaleingang, der an den Signalausgang durchgeschaltet ist, Signale, insbesondere elektrische und/oder optische Signale, von dem Signaleingang an den Signalausgang des Multiplexers übertragen werden. Bei den Signalen handelt es sich vorzugsweise um Magnetresonanzsignale, die zuvor von dem aktiven Empfangsspulenelement - wie oben beschrieben - empfangen wurden.

Möglicherweise wird das Magnetresonanzsignal nach dem Empfang durch das aktive Empfangsspulenelement und vor Einkopplung über den Signaleingang in den Multiplexer modifiziert. Beispielsweise werden die Magnetresonanzsignale mit einem Trägersignal gemischt. Dadurch kann ein Zwischenfrequenzsignal erzeugt werden.

Vorzugsweise wird zu einem Zeitpunkt immer nur ein Signaleingang an den Signalausgang durchgeschaltet, d.h. es werden nicht zwei oder mehr Signalausgänge gleichzeitig an den Signalausgang durchgeschaltet.

Eine weitere Ausführungsform des Verfahrens sieht vor, dass der Multiplexer permanent einen der Signaleingänge, die mit jeweils einem aktiven Empfangsspulenelement verbunden sind, an den Signalausgang durchschaltet. Hierbei bedeutet permanent, dass das Durchschalten natürlich von etwaigen kurzen Schaltvorgängen unterbrochen werden kann.

Dadurch dass der Multiplexer permanent einen der Signaleingänge, die mit jeweils einem aktiven Empfangsspulenelement verbunden sind, an den Signalausgang durchschaltet, können durchgehend wertvolle Magnetresonanzsignale durch die Magnetresonanzvorrichtung aufgenommen werden, so dass sich die Datenbasis für die Rekonstruktion der MR-Abbildungen verbessert. Die Untersuchungszeit des Patienten kann somit optimal ausgenutzt werden.

Dabei wird erfindungsgemäß nicht immer derselbe der Signaleingänge durchgeschaltet, d.h. der eine durchgeschaltete Signaleingang wechselt zwischen den Signaleingängen, die mit den aktiven Empfangsspulenelementen verbunden sind.

Erfindungsgemäß weist die Magnetresonanzvorrichtung ein erstes und ein zweites aktives Empfangsspulenelement auf, mit denen Magnetresonanzsignale empfangen werden.

Erfindungsgemäß ist jedes der aktiven Empfangsspulenelemente mit jeweils einem der Signaleingänge verbunden. Erfindungsgemäß weist der Multiplexer eine Anzahl an Signaleingängen auf, die größer ist als die Anzahl der aktiven Empfangsspulenelemente, d.h. die Anzahl der Signaleingänge beträgt mindestens drei.

Vorzugsweise schaltet der Multiplexer die Signaleingänge, die mit jeweils einem aktiven Empfangsspulenelement verbunden sind, wiederholt durch. Dadurch können von einem aktiven Empfangsspulenelement wiederholt Magnetresonanzsignale über den Multiplexer übertragen werden, was eine bessere Auswertung der Magnetresonanzsignale ermöglicht.

Erfindungsgemäß beträgt die Anzahl der aktiven Empfangsspulenelemente zwei, wobei der Multiplexer nacheinander die Signaleingänge, die mit jeweils einem der zwei aktiven Empfangsspulenelemente verbunden sind, an den Signalausgang durchschaltet.

Erfindungsgemäß sind ein erstes aktives Empfangsspulenelement mit einem ersten Signaleingang, ein zweites aktives Empfangsspulenelement mit einem zweiten Signaleingang verbunden.

Sukzessive können der erste und der zweite Signaleingang an den Signalausgang durchgeschalten werden, d.h. erst wird der erste Signaleingang durchgeschalten und danach wird der zweite Signaleingang durchgeschalten. Die Magnetresonanzsignale, die vom ersten und zweiten Empfangsspulenelement empfangen werden, können somit in einem Zeitmultiplexverfahren auf den Signalausgang des Multiplexers übertragen werden. Eine sukzessive Durschaltung der Signaleingänge ermöglicht eine besonders einfache Betriebsweise des Multiplexers.

Bevorzugt schaltet der Multiplexer die Signaleingänge, die mit jeweils einem aktiven Empfangsspulenelement verbunden sind, in einer gleichen Reihenfolge an den Signalausgang durch. Beispielsweise werden in einem ersten Durchlauf zuerst ein erster Signaleingang durchgeschalten und dann ein zweiter Signaleingang, wobei in einem darauf folgenden zweiten Durchlauf wiederum zuerst der erste Signaleingang durchgeschalten wird und dann der zweite Signaleingang. Somit ist die Reihenfolge im ersten Durchgang die gleiche wie im zweiten Durchgang. Auch dies ermöglicht eine besonders einfache Betriebsweise des Multiplexers.

Vorzugsweise schaltet der Multiplexer die Signaleingänge, die mit jeweils einem aktiven Empfangsspulenelement verbunden sind, über gleiche lange Zeiträume an den Signalausgang durch. Mit anderen Worten sind in diesem Fall die Zeitabschnitte bzw. Zeitschlitze gleich lang, in denen von den jeweiligen Signaleingängen Signale an den Signalausgang übertragen werden. Auch dies ermöglicht eine besonders einfache Betriebsweise des Multiplexers.

Vorzugsweise ist der Signalausgang mit einem Analog-Digital-Wandler (engl. analog-to-digital converter, ADC) verbunden. Dadurch können über den Multiplexer übertragene analoge Signale in digitale Signale umgesetzt werden. Insbesondere können mit dem Analog-Digital-Wandler vorab beschriebene Zwischenfrequenzsignale abgetastet werden.

Erfindungsgemäß werden alle aktiven Empfangsspulenelemente von einer Ganzkörperspule der Magnetresonanzvorrichtung umfasst. Üblicherweise weist die Ganzkörperspule eine vergleichsweise geringe Anzahl an Empfangsspulenelementen auf.

Vorzugsweise beträgt die Anzahl der Signaleingänge des Multiplexers mindestens vier, insbesondere mindestens acht, insbesondere mindestens sechzehn.

Vorzugsweise beträgt das Verhältnis der Anzahl der Signaleingänge des Multiplexers zur Anzahl der aktiven Empfangsspulenelemente mindestens zwei, insbesondere mindestens drei, insbesondere mindestens vier. Je höher dieses Verhältnis ist, desto größer ist die verwertbare Datenbasis für eine Bildrekonstruktion verglichen mit einer herkömmlichen Betriebsweise des Multiplexers.

Vorzugsweise werden die durch die aktiven Empfangsspulenelemente empfangenen Magnetresonanzsignale durch eine Auswerteeinheit der Magnetresonanzvorrichtung ausgewertet. Dazu werden beispielsweise Magnetresonanzsignale vom Signalausgang des Multiplexers zu der Auswerteeinheit übertragen. Insbesondere werden die Magnetresonanzsignale nach einer Digitalisierung durch einen Analog-Digital-Wandler ausgewertet.

Vorzugsweise werden die empfangenen Magnetresonanzsignale durch die Auswerteeinheit gemittelt, d.h. es wird anhand der empfangenen Magnetresonanzsignale zumindest ein Mittelwert gebildet. Dabei werden vorzugsweise nur die Magnetresonanzsignale miteinander gemittelt, die von jeweils demselben aktiven Empfangsspulenelement empfangen wurden. Dadurch kann ein Signal-Rausch-Verhältnis (engl. Signal-to-noise ratio, SNR) der rekonstruierten MR-Abbildungen verbessert werden.

Ferner wird eine Magnetresonanzvorrichtung zum Empfang von Magnetresonanzsignalen gemäß Anspruch 10 vorgeschlagen.

Die Vorteile der Magnetresonanzvorrichtung zum Empfang von Magnetresonanzsignalen entsprechen im Wesentlichen den Vorteilen des Verfahrens zum Empfang von Magnetresonanzsignalen, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Ferner wird ein Computerprogrammprodukt gemäß Anspruch 12 vorgeschlagen, das ein Programm umfasst und direkt in einen Speicher einer programmierbaren Recheneinheit einer Magnetresonanzvorrichtung ladbar ist und Programmmittel, z.B. Bibliotheken und Hilfsfunktionen, aufweist, um ein vorab beschriebenes Verfahren zum Empfang von Magnetresonanzsignalen auszuführen, wenn das Computerprogrammprodukt in der Recheneinheit ausgeführt wird. Das Computerprogrammprodukt kann dabei eine Software mit einem Quellcode, der noch kompiliert und gebunden oder der nur interpretiert werden muss, oder einen ausführbaren Softwarecode umfassen, der zur Ausführung nur noch in die Überprüfungseinheit zu laden ist. Durch das Computerprogrammprodukt kann das Verfahren zum Empfang von Magnetresonanzsignalen schnell, identisch wiederholbar und robust ausgeführt werden. Das Computerprogrammprodukt ist so konfiguriert, dass es mittels der Recheneinheit die erfindungsgemäßen Verfahrensschritte ausführen kann. Die Recheneinheit muss dabei jeweils die Voraussetzungen wie beispielsweise einen entsprechenden Arbeitsspeicher, eine entsprechende Grafikkarte oder eine entsprechende Logikeinheit aufweisen, so dass die jeweiligen Verfahrensschritte effizient ausgeführt werden können.

Das Computerprogrammprodukt ist beispielsweise auf einem computerlesbaren Medium gespeichert oder auf einem Netzwerk oder Server hinterlegt, von wo es in den Prozessor einer lokalen Recheneinheit geladen werden kann. Weiterhin können Steuerinformationen des Computerprogrammprodukts auf einem elektronisch lesbaren Datenträger gespeichert sein. Die Steuerinformationen des elektronisch lesbaren Datenträgers können derart ausgestaltet sein, dass sie bei Verwendung des Datenträgers in einer Recheneinheit ein erfindungsgemäßes Verfahren durchführen. Beispiele für elektronische lesbare Datenträger sind eine DVD, ein Magnetband oder einen USB-Stick, auf welchem elektronisch lesbare Steuerinformationen, insbesondere Software, gespeichert ist. Wenn diese Steuerinformationen von dem Datenträger gelesen und in eine Recheneinheit gespeichert werden, können alle erfindungsgemäßen Ausführungsformen der vorab beschriebenen Verfahren durchgeführt werden. So kann die Erfindung auch von dem besagten computerlesbaren Medium und/oder dem besagten elektronisch lesbaren Datenträger ausgehen.

Weitere Vorteile, Merkmale und Einzelheiten der Erfindung ergeben sich aus den im Folgenden beschriebenen Ausführungsbeispielen sowie anhand der Zeichnungen. Einander entsprechende Teile sind in allen Figuren mit den gleichen Bezugszeichen versehen.

Es zeigen:
- Fig. 1: eine Magnetresonanzvorrichtung,
- Fig. 2: eine Schaltanordnung mit n aktiven Empfangsspulenelementen und m Signaleingängen, die für den gezeigten allgemeinen Fall nicht in den durch die Ansprüche definierten Schutzumfang der Erfindung fällt,
- Fig. 3: ein zeitlicher Schaltablauf für n aktive Empfangsspulenelementen und m Signaleingänge gemäß dem Stand der Technik,
- Fig. 4: ein zeitlicher Schaltablauf für n aktive Empfangsspulenelementen und m Signaleingänge, der für den gezeigten allgemeinen Fall nicht in den durch die Ansprüche definierten Schutzumfang der Erfindung fällt,
- Fig. 5: ein zeitlicher Schaltablauf für 2 aktive Empfangsspulenelementen und 4 Signaleingänge gemäß dem Stand der Technik,
- Fig. 6: ein zeitlicher Schaltablauf für 2 aktive Empfangsspulenelementen und 4 Signaleingänge,
- Fig. 7: ein Verfahren, das nicht alle Merkmale des Verfahrens gemäß Anspruch 1 enthält und daher als solches nicht in den durch die Ansprüche definierten Schutzumfang der Erfindung fällt.

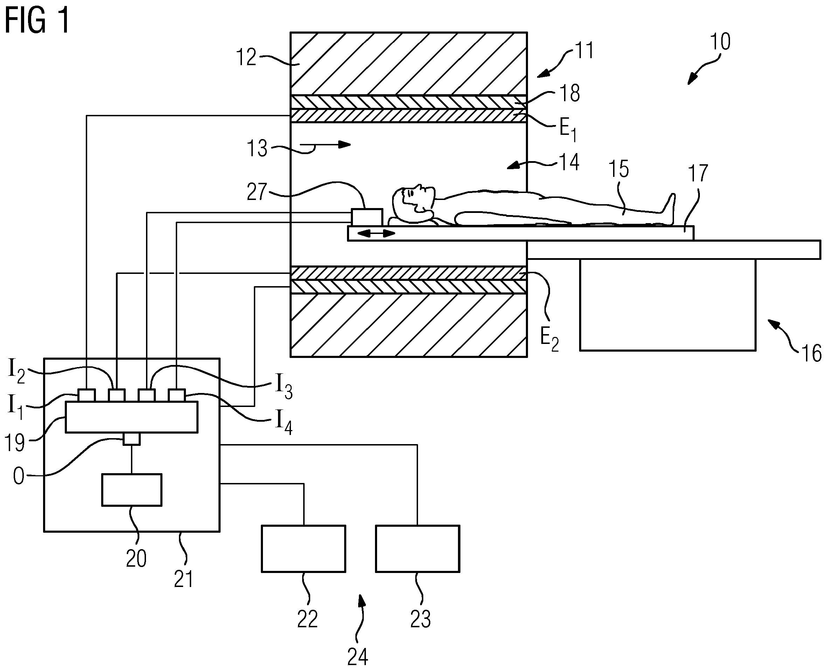

In Fig. 1 ist eine Magnetresonanzvorrichtung 10 schematisch dargestellt. Die Magnetresonanzvorrichtung 10 umfasst eine Magneteinheit 11, die einen Hauptmagneten 12 zu einem Erzeugen eines starken und insbesondere zeitlich konstanten Hauptmagnetfelds 13 aufweist. Zudem umfasst die Magnetresonanzvorrichtung 10 einen Patientenaufnahmebereich 14 zu einer Aufnahme eines Patienten 15. Der Patientenaufnahmebereich 14 im vorliegenden Ausführungsbeispiel ist zylinderförmig ausgebildet und in einer Umfangsrichtung von der Magneteinheit 11 zylinderförmig umgeben. Grundsätzlich ist jedoch eine davon abweichende Ausbildung des Patientenaufnahmebereichs 14 jederzeit denkbar. Der Patient 15 kann mittels einer Patientenlagerungsvorrichtung 16 der Magnetresonanzvorrichtung 10 in den Patientenaufnahmebereich 14 geschoben werden. Die Patientenlagerungsvorrichtung 16 weist hierzu einen innerhalb des Patientenaufnahmebereichs 14 bewegbar ausgestalteten Patiententisch 17 auf.

Die Magneteinheit 11 weist weiterhin eine Gradientenspuleneinheit 18 zu einer Erzeugung von Magnetfeldgradienten auf, die für eine Ortskodierung während einer Bildgebung verwendet werden. Die Gradientenspuleneinheit 18 wird mittels einer Systemsteuereinheit 21 der Magnetresonanzvorrichtung 10 gesteuert. Die Magneteinheit 11 umfasst weiterhin eine fest in die Magnetresonanzvorrichtung 10 integrierte Ganzkörperspule mit zwei Empfangsspulenelementen E₁, E₂. Die Empfangsspulenelementen E₁, E₂ dienen in diesem Beispiel zudem als Sendeantennen, um Anregungspulse in einen Untersuchungsraum einzustrahlen, der im Wesentlichen von einem Patientenaufnahmebereich 14 der Magnetresonanzvorrichtung 10 gebildet ist.

Die eingestrahlten Anregungspulse sind in der Lage, Kernspins im Körper des Patienten 15 auszulenken. Die ausgelenkten Kernspins geben wiederum Magnetresonanzsignale ab, die von den Empfangsspulenelementen E₁, E₂ erfasst werden. Somit handelt es sich bei den zwei Empfangsspulenelementen E₁, E₂ um aktive Empfangsspulenelemente E₁, E₂.

Die durch die aktiven Empfangsspulenelementen E₁, E₂ empfangenen Magnetresonanzsignale sind mit Signaleingängen I₁, I₂ eines Multiplexers 19 verbunden, der durch die Systemsteuereinheit 21 angesteuert wird. Der Multiplexer 19 umfasst zudem weitere Signaleingänge I₂, I₄, die mit einem Steckplatz 27 verbunden sind, der am Patiententisch 17 angeordnet ist.

Es bestünde die Möglichkeit, über den Steckplatz 27 etwaige Lokalspulen mit Empfangsspulenelementen an die Magnetresonanzvorrichtung anzuschließen, was jedoch hier nicht der Fall ist. Somit sind die Signaleingänge I₃, I₄ hier mit keinen, insbesondere keinen aktiven, Empfangsspulenelementen verbunden.

Der Multiplexer 19 weist einen Signalausgang O auf, an den einer der Signaleingänge I₁, I₂, I₃, I₄ durchgeschaltet werden kann. Der Signalausgang O ist mit einer Auswerteeinheit 20 verbunden. Die Auswerteeinheit 20 ist ausgebildet zu einer Auswertung der Magnetresonanzsignale, die während der Magnetresonanzuntersuchung erfasst werden.

Des Weiteren umfasst die Magnetresonanzvorrichtung 10 eine Benutzerschnittstelle 24, die mit der Systemsteuereinheit 21 verbunden ist. Steuerinformationen wie beispielsweise Bildgebungsparameter, sowie rekonstruierte Magnetresonanzbilder können auf einer Anzeigeeinheit 22, beispielsweise auf einem Monitor, der Benutzerschnittstelle 24 für ein medizinisches Bedienpersonal angezeigt werden. Weiterhin weist die Benutzerschnittstelle 24 eine Eingabeeinheit 23 auf, mittels der Informationen und/oder Parameter während eines Messvorgangs von dem medizinischen Bedienpersonal eingegeben werden können.

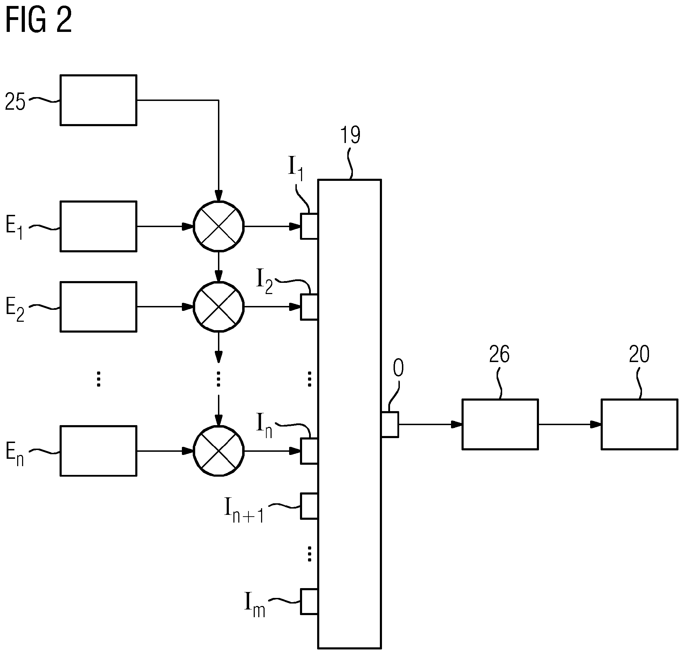

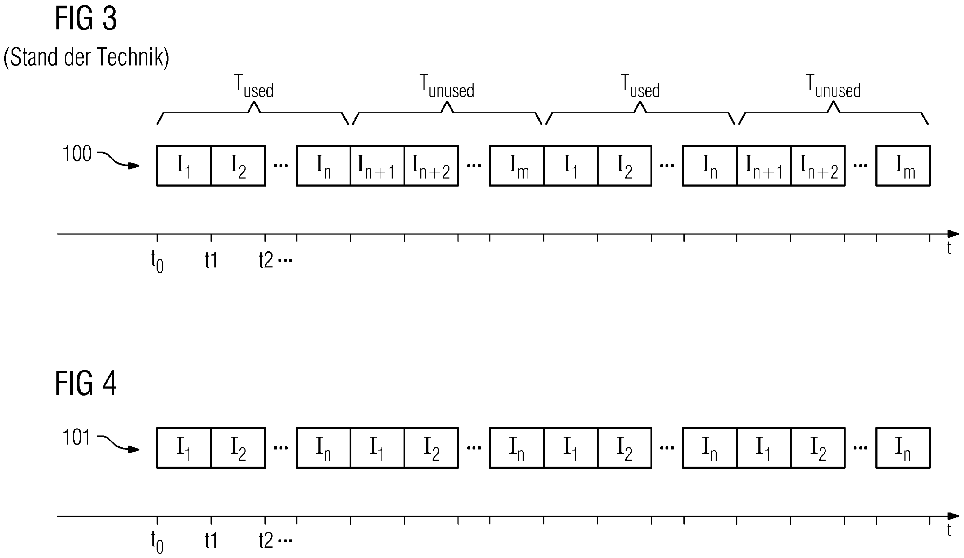

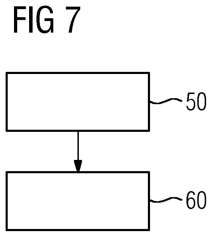

Anhand der Fig. 2 bis 5 wird die vorliegende Erfindung beispielhaft näher erklärt, wobei die Ausführungsformen gemäß der Fig. 2 und 4 nicht in den durch die Ansprüche definierten Schutzumfang der Erfindung fallen. In Fig. 7 ist ein exemplarisches Verfahren zum Empfang von Magnetresonanzsignalen durch eine Magnetresonanzvorrichtung dargestellt. Das Verfahren enthält nicht alle Merkmale des Verfahrens gemäß Anspruch 1 und fällt daher als solches nicht in den durch die Ansprüche definierten Schutzumfang der Erfindung. Die Systemsteuereinheit 21 umfasst eine in Fig. 1 nicht weiter dargestellte programmierbare Recheneinheit, die einen Speicher aufweist, in welchen ein Computerprogrammprodukt zur Durchführung dieses Verfahrens ladbar ist.

In Verbindung mit Fig. 2 wird das exemplarische Verfahren näher erläutert. In einem Schritt 50 werden mit einer Anzahl n an aktiven Empfangsspulenelementen E₁, ..., Eₙ der Magnetresonanzvorrichtung 10 Magnetresonanzsignale empfangen, wobei n≥1 ist.

Ferner weist die Magnetresonanzvorrichtung einen Multiplexer 19 mit einem Signalausgang O und m Signaleingängen I₁, ..., Iₘ auf, wobei m≥2. Dabei ist ein Teil der mehreren Signaleingänge I₁, ..., Iₙ mit jeweils einem aktiven Empfangsspulenelement E₁, ..., Eₙ verbunden. Hingegen ist der restliche Teil I₁ₙ₊₁, ..., Iₘ der m Signaleingänge mit keinem aktiven Empfangsspulenelement verbunden. Die Anzahl der Signaleingänge m ist größer als die Anzahl der aktiven Empfangsspulenelemente n.

In einem Schritt 60 schaltet der Multiplexer 19 zumindest einen Teil des restlichen Teils I₁ₙ₊₁, ..., Iₘ der mehreren Signaleingänge, der mit keinem aktiven Empfangsspulenelement verbunden ist, nicht an den Signalausgang O durch. In diesem Beispiel wird der gesamte restliche Teils I₁ₙ₊₁, ..., Iₘ der mehreren Signaleingänge, der mit keinem aktiven Empfangsspulenelement verbunden ist, nicht an den Signalausgang O durchgeschalten.

Insbesondere schaltet der Multiplexer 19 in Schritt 60 permanent, also nur durch etwaige Schaltzeiten unterbrochen, einen der Signaleingänge I₁, ..., Iₙ, die mit jeweils einem aktiven Empfangsspulenelement E₁, ..., Eₙ verbunden sind, an den Signalausgang O durch.

Während einer Magnetresonanzuntersuchung werden die Schritte 50 und 60 üblicherweise laufend wiederholt, d.h. es werden immer wieder neue Magnetresonanzsignale in Schritt 50 empfangen, die über den Muliplexer 19 in Schritt 60 auf den Signalausgang O übertragen werden.

Die in Fig. 2 beispielhaft dargestellte Anordnung weist einen optionalen Signalgenerator 25 auf, der die durch die aktiven Empfangsspulenelemente E₁, ..., Eₙ empfangenen Magnetresonanzsignale mit einem Trägersignal mischt. Daraus resultiert ein Zwischenfrequenzsignal, das in die Signaleingänge I₁, ..., Iₙ des Multiplexers 19 eingekoppelt wird.

Wie bereits erläutert, weist der Multiplexer 19 neben den Signaleingänge I₁, ..., Iₙ, die mit den aktiven Empfangsspulenelementen E₁, ..., Eₙ verbunden sind, noch weitere Signaleingänge Iₙ₊₁, ..., Iₘ auf, die mit keinem aktiven Empfangsspulenelement verbunden sind. Das schließt nicht aus, dass die weiteren Signaleingänge Iₙ₊₁, ..., Iₘ möglicherweise mit einen oder mehreren nicht-aktiven Empfangsspulenelementen verbunden sein können, jedoch werden etwaige Signale, die durch diese weiteren Signaleingänge Iₙ₊₁, ..., Iₘ in den Multiplexer 19 eingespeist werden, nicht weiter ausgewertet. Solche nicht-aktiven Empfangsspulenelemente können beispielsweise fest mit dem Multiplexer 19 verbundene Empfangsspulenelemente sein, die nur bei Bedarf hinzugeschaltet werden und nur dann aktive Empfangsspulenelemente sind, aber ansonsten eben nicht-aktive Empfangsspulenelemente.

Die über die Signaleingänge I₁,..., Iₙ eingekoppelten Magnetresonanzsignale werden an den Signalausgang O durchgeschaltet. Üblicherweise werden die Magnetresonanzsignale bzw. Zwischenfrequenzsignale mittels eines Analog-Digital-Wandler 26 digitalisiert, z.B. durch eine Abtastung mit 10 MHz, und dann mittels einer Auswerteeinheit 20 ausgewertet. Durch den Einsatz von einem oder mehreren Multiplexern 19 kann die Anzahl der notwendigen Analog-Digital-Wandler 26 in der Magnetresonanzvorrichtung 10 reduziert werden, indem ein einzelner Analog-Digital-Wandler 26 mehrere Analogsignale im Zeitmultiplex abtastet und der Auswerteeinheit 20 für die weitere Verarbeitung zur Verfügung stellt.

In Fig. 3 und 4 wird gegenübergestellt, wie sich eine herkömmliche Betriebsweise 100 des Multiplexers 19 gemäß dem Stand der Technik - wie oben in Fig. 3 abgebildet - von einer exemplarischen Betriebsweise 101 - wie unten in Fig. 4 abgebildet - unterscheidet. Konventionell werden alle Signaleingänge I₁, ..., Iₘ des Multiplexers 19 nacheinander durchgeschaltet, also auch die Signaleingänge Iₙ₊₁, ..., Iₘ, die keine nutzbaren Magnetresonanzsignale liefern. An einem Zeitraum zwischen t₀ und t₁, in dem I₁ durchgeschaltet wird, schließt sich ein Zeitraum zwischen t₁ und t₂ an, in dem I₂ durchschaltet wird, usw. bis sich ein Zeitraum anschließt, an dem auch der letzte Signaleingang Iₘ durchgeschaltet wird. Daran schließt sich ein Zeitraum an, an dem I₁ wieder durchgeschaltet wird und der Zyklus beginnt von neuem. Durch diese herkömmliche Betriebsweise 100 wird nur ein Teil der Messzeit T_{used} effektiv genutzt, während in einem weiteren Teil der Messzeit T_{unused} keine auswertbaren Magnetresonanzsignale aufgenommen werden, d.h. die unbenutzten Zeitschlitze während T_{unused} führen kein Signal.

Hingegen werden gemäß der beispielhaften Betriebsweise 101 permanent einer der Signaleingänge I₁ bis Iₙ, die mit jeweils einem aktiven Empfangsspulenelement E₁ bis Eₙ verbunden sind, an den Signalausgang O durchgeschaltet. An einen Zeitraum, in dem Iₙ durchgeschaltet wird, schließt sich hier also nicht ein Zeitraum an, an dem Iₙ₊₁ durchgeschaltet wird, sondern es wird sofort wieder mit einem neuen Zyklus begonnen, in dem Signaleingänge I₁, ..., Iₙ durchgeschaltet werden, die jeweils einem aktiven Empfangsspulenelement I₁, ..., Iₙ verbunden sind. Dadurch entstehen keine ungenutzten Messzeiten T_{unused}, sondern es werden zusätzliche Daten während der bisher unbenutzten Zeitschlitze abgetastet. Dies ermöglicht eine schnellere Messung und/oder eine Aufnahme einer größeren Datenmenge. Eine größere Datenmenge kann beispielsweise dazu genutzt werden, die empfangenen Magnetresonanzsignale durch die Auswerteeinheit 20 zu mitteln, um etwaiges Rauschen zu reduzieren.

Selbstverständlich kann die permanente Durchschaltung durch etwaige technisch notwendige Schaltzeiten zwischen den Durchschalt-Zeiträumen unterbrochen sein. Die permanente Durchschaltung könnte also auch als quasi-permanente Durschaltung bezeichnet werden, um diese für den Fachmann selbstverständliche Einschränkung zu berücksichtigen.

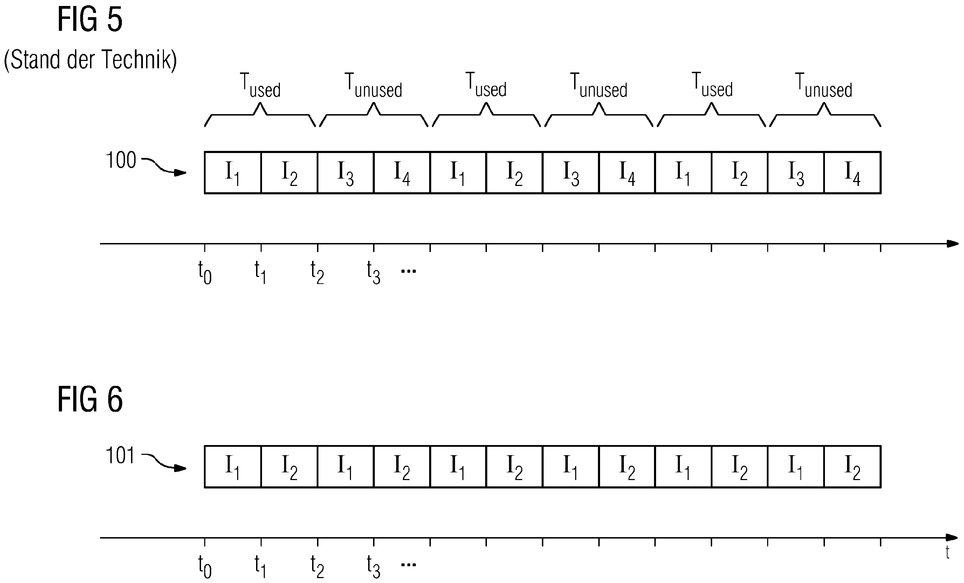

In Fig. 5 und 6 wird entsprechend dem in Fig. 1 gezeigten Beispiel ein weiterer Schaltablauf über der Zeit t dargestellt. Gemäß Fig. 1 umfasst die Ganzkörperspule zwei aktive Empfangsspulenelemente E₁, E₂, deren Signale über die Signaleingänge I₁, I₂ durch eine Verarbeitungskette geführt werden.

Die konventionelle Betriebsweise 100 gemäß dem Stand der Technik in Fig. 5 sieht vor, dass alle Signaleingänge I₁ bis I₄ nacheinander durchgeschalten werden, auch wenn nur zwei aktive Empfangsspulenelemente E₁, E₂ verbunden sind. So wird beispielsweise in einem Zeitraum zwischen t₂ und t₃ kein aktives Empfangsspulenelement durchgeschalten.

Wie in Fig. 6 gezeigt wird, schaltet in diesem Ausführungsbeispiel der Erfindung der Multiplexer 19 gemäß der Betriebsweise 101 die Signaleingänge I₁, I₂, die mit jeweils einem der aktiven Empfangsspulenelemente E₁, E₂ verbunden sind, wiederholt durch, d.h. die Zeiträume für I₁ und I₂ wiederholen sich entlang der Zeit t immer wieder. So wird beispielsweise in dem Zeitraum zwischen t₂ und t₃, der im Stand der Technik gemäß Fig. 5 ungenutzt bleibt, der Signaleingang I₁ und damit das aktives Empfangsspulenelement E₁ durchgeschalten.

Zudem wird gezeigt, dass der Multiplexer 19 nacheinander die Signaleingänge I₁, I₂ durchschaltet, die mit jeweils einem der aktiven Empfangsspulenelemente E₁, E₂ verbunden sind, d.h. erst I₁ und danach I₂ usw. Die Reihenfolge bleibt hierbei in jedem Zyklus gleich, also immer erst I₁ und dann I₂. Ferner sind auch die Zeiträume, über die der Multiplexer 19 die Signaleingänge durchschaltet, gleich lang.

Die Anzahl n der aktiven Empfangsspulenelemente E₁, ..., Eₙ beträgt erfindungsgemäß zwei, die von der Ganzkörperspule der Magnetresonanzvorrichtung 10 umfasst werden. Falls wie bei der Erfindung eine Bilderfassung nur mit der Ganzkörperspule erfolgt, die erfindungsgemäß nur zwei Empfangskanäle aufweist, so dass die Anzahl m der Signaleingänge I₁, ..., Iₘ des Multiplexers 19 die Anzahl n = 2 der aktiven Empfangsspulenelemente E₁, ..., Eₙ deutlich übersteigt, kann das vorgeschlagene Verfahren sehr vorteilhaft eingesetzt werden.

Vorzugsweise beträgt die Anzahl m der Signaleingänge I₁, ..., Iₘ mindestens vier, wie in diesem Fall. Entsprechend dem Verhältnis m/n der Anzahl m der Signaleingänge zur Anzahl n der aktiven Empfangsspulenelemente können in dem in Fig. 1 und 4 gezeigten Beispiel doppelt so viele Daten aufgenommen werden gegenüber der konventionellen Betriebsweise 101.

Es wird abschließend noch einmal darauf hingewiesen, dass es sich bei den vorhergehend detailliert beschriebenen Verfahren sowie bei der dargestellten Magnetresonanzvorrichtung lediglich um Ausführungsbeispiele handelt, welche vom Fachmann in verschiedenster Weise modifiziert werden können, ohne den Bereich der Erfindung zu verlassen, der durch die Ansprüche definiert wird. Weiterhin schließt die Verwendung der unbestimmten Artikel "ein" bzw. "eine" nicht aus, dass die betreffenden Merkmale auch mehrfach vorhanden sein können. Ebenso schließt der Begriff "Einheit" nicht aus, dass die betreffenden Komponenten aus mehreren zusammenwirkenden Teil-Komponenten bestehen, die gegebenenfalls auch räumlich verteilt sein können.

## Patentansprüche

1. Verfahren zum Empfang von Magnetresonanzsignalen durch eine Magnetresonanzvorrichtung,
wobei die Magnetresonanzvorrichtung zumindest ein aktives Empfangsspulenelement aufweist, mit der Magnetresonanzsignale empfangen werden,
wobei die Magnetresonanzvorrichtung einen Multiplexer mit einem Signalausgang und mehreren Signaleingängen aufweist,
wobei ein erstes aktives Empfangsspulenelement mit einem ersten Signaleingang und ein zweites aktives Empfangsspulenelement mit einem zweiten Signaleingang verbunden ist, wobei der Multiplexer eine Anzahl an Signaleingängen aufweist, die größer als die Anzahl der aktiven Empfangsspulenelemente ist,
wobei der restliche Teil der mehreren Signaleingänge mit keinem aktiven Empfangsspulenelement verbunden ist,
wobei der Multiplexer während des Empfangs der Magnetresonanzsignale nacheinander die Signaleingänge, die mit jeweils einem aktiven Empfangsspulenelement verbunden sind, an den Signalausgang durchschaltet, wobei der Multiplexer zumindest einen Teil des restlichen Teils der mehreren Signaleingänge, der mit keinem aktiven Empfangsspulenelement verbunden ist, nicht an den Signalausgang durchschaltet,
wobei eine fest in die Magnetresonanzvorrichtung eingebaute Ganzkörperspule alle aktiven Empfangsspulenelemente umfasst.

2. Verfahren nach Anspruch 1,
**dadurch gekennzeichnet,**
**dass** der Multiplexer permanent einen der Signaleingänge, die mit jeweils einem aktiven Empfangsspulenelement verbunden sind, an den Signalausgang durchschaltet, so dass das Durchschalten nur von etwaigen kurzen Schaltvorgängen unterbrochen wird.

3. Verfahren nach einem der Ansprüche 1 oder 2,
**dadurch gekennzeichnet,**
**dass** der Multiplexer die Signaleingänge, die mit jeweils einem aktiven Empfangsspulenelement verbunden sind, wiederholt an den Signalausgang durchschaltet.

4. Verfahren nach einem der vorangehenden Ansprüche,
**dadurch gekennzeichnet,**
**dass** der Multiplexer die Signaleingänge, die mit jeweils einem aktiven Empfangsspulenelement verbunden sind, in einer gleichen Reihenfolge an den Signalausgang durchschaltet.

5. Verfahren nach einem der vorangehenden Ansprüche,
**dadurch gekennzeichnet,**
**dass** der Multiplexer die Signaleingänge, die mit jeweils einem aktiven Empfangsspulenelement verbunden sind, über gleich lange Zeiträume an den Signalausgang durchschaltet.

6. Verfahren nach einem der vorangehenden Ansprüche,
**dadurch gekennzeichnet,**
**dass** der Signalausgang mit einem Analog-Digital-Wandler verbunden ist.

7. Verfahren nach einem der vorangehenden Ansprüche,
**dadurch gekennzeichnet,**
**dass** die Anzahl der Signaleingänge mindestens vier ist.

8. Verfahren nach einem der vorangehenden Ansprüche,
**dadurch gekennzeichnet,**
**dass** die durch die aktiven Empfangsspulenelemente empfangenen Magnetresonanzsignale durch eine Auswerteeinheit der Magnetresonanzvorrichtung ausgewertet werden.

9. Verfahren nach Anspruch 8,
**dadurch gekennzeichnet,**
**dass** die empfangenen Magnetresonanzsignale durch die Auswerteeinheit gemittelt werden.

10. Magnetresonanzvorrichtung zum Empfang von Magnetresonanzsignalen,
wobei die Magnetresonanzvorrichtung ein erstes aktives Empfangsspulenelement und ein zweites aktives Empfangsspulenelement aufweist, welche ausgebildet sind, Magnetresonanzsignale zu empfangen, wobei die Magnetresonanzvorrichtung einen Multiplexer mit einem Signalausgang und mehreren Signaleingängen aufweist,
wobei das erste aktive Empfangsspulenelement mit einem ersten Signaleingang und das zweite aktive Empfangsspulenelement mit einem zweiten Signaleingang verbunden ist, wobei der Multiplexer eine Anzahl an Signaleingängen aufweist, die größer als die Anzahl der aktiven Empfangsspulenelemente ist,
wobei der restliche Teil der mehreren Signaleingänge mit keinem aktiven Empfangsspulenelement verbunden ist,
wobei der Multiplexer ausgebildet ist, während des Empfangs der Magnetresonanzsignale nacheinander die Signaleingänge, die mit jeweils einem aktiven Empfangsspulenelement verbunden sind, an den Signalausgang durchzuschalten und zumindest einen Teil des restlichen Teils der mehreren Signaleingänge, der mit keinem aktiven Empfangsspulenelement verbunden ist, nicht an den Signalausgang durchzuschalten,
wobei eine fest in die Magnetresonanzvorrichtung eingebaute Ganzkörperspule alle aktiven Empfangsspulenelemente umfasst.

11. Magnetresonanzvorrichtung nach Anspruch 10, welche ausgebildet ist, ein Verfahren nach einem der Ansprüche 2 bis 9 durchzuführen.

12. Computerprogrammprodukt, welches ein Programm umfasst und direkt in einen Speicher einer programmierbaren Recheneinheit einer Magnetresonanzvorrichtung ladbar ist, mit Programmmitteln, um ein Verfahren nach einem der Ansprüche 1 bis 9 auszuführen, wenn das Programm in der Recheneinheit ausgeführt wird.

## Claims

1. Method for receiving magnetic resonance signals by means of a magnetic resonance device,
wherein the magnetic resonance device has at least one active receive coil element, with which magnetic resonance signals are received,
wherein the magnetic resonance device has a multiplexer with a signal output and a number of signal inputs,
wherein a first active receive coil element is connected to a first signal input and a second active receive coil element is connected to a second signal input, wherein the multiplexer has a number of signal inputs which is larger than the number of active receive coil elements,
wherein the remaining part of the number of signal inputs is not connected to an active receive coil element,
wherein while the magnetic resonance signals are received consecutively, the multiplexer interconnects the signal inputs, which are connected to an active receive coil element in each case, with the signal output, wherein the multiplexer does not interconnect at least one part of the remaining part of the number of signal inputs, which is not connected to an active receive coil element, with the signal output, wherein a whole body coil integrated fixedly in the magnetic resonance device comprises all active receive coil elements.

2. Method according to claim 1,
**characterised in that**
the multiplexer permanently interconnects one of the signal inputs, which are connected to an active receive coil element in each case, with the signal output so that the interconnection is only interrupted by any short switching processes.

3. Method according to one of claims 1 or 2,
**characterised in that**
the multiplexer repeatedly interconnects the signal inputs, which are connected to an active receive coil element in each case, with the signal output.

4. Method according to one of the preceding claims,
**characterised in that**
the multiplexer consecutively interconnects the signal inputs, which are connected to an active receive coil element in each case, with the signal output.

5. Method according to one of the preceding claims,
**characterised in that**
the multiplexer interconnects the signal inputs, which are connected to an active receive coil element in each case, with the signal output during time frames of equal length.

6. Method according to one of the preceding claims,
**characterised in that**
the signal output is connected to an analogue-digital converter.

7. Method according to one of the preceding claims,
**characterised in that**
the number of signal inputs is at least four.

8. Method according to one of the preceding claims,
**characterised in that**
the magnetic resonance signals received by the active receive coil elements are evaluated by an evaluation unit of the magnetic resonance device.

9. Method according to claim 8,
**characterised in that**
the received magnetic resonance signals are averaged by means of the evaluation unit.

10. Magnetic resonance device for receiving magnetic resonance signals,
wherein the magnetic resonance device has a first active receive coil element and a second active receive coil element,
which are embodied to receive magnetic resonance signals, wherein the magnetic resonance device has a multiplexer with a signal output and a number of signal inputs,
wherein the first active receive coil element is connected to a first signal input and the second active receive coil element is connected to a second signal input, wherein the multiplexer has a number of signal inputs which is larger than the number of active receive coil elements,
wherein the remaining part of the number of signal inputs is not connected to an active receive coil element,
wherein while the magnetic resonance signals are received consecutively, the multiplexer is embodied to interconnect the signal inputs, which are connected to an active receive coil element in each case, with the signal output and not to interconnect at least one part of the remaining part of the number of signal inputs, which is not connected to an active receive coil element, with the signal output, wherein a whole body coil integrated fixedly in the magnetic resonance device comprises all active receive coil elements.

11. Magnetic resonance device according to claim 10,
which is embodied to carry out a method according to one of claims 2 to 9.

12. Computer program product which comprises a program and is directly loadable into a memory store of a programmable computing unit of a magnetic resonance device, comprising program means in order to carry out a method according to one of claims 1 to 9 when the program is executed in the computing unit.

## Revendications

1. Procédé de réception de signaux de résonnance magnétique par un dispositif à résonnance magnétique,
dans lequel le dispositif à résonnance a au moins un élément actif de bobine de réception, par lequel des signaux de résonnance magnétique sont reçus,
dans lequel le dispositif à résonnance magnétique a un multiplexeur ayant une sortie du signal et plusieurs entrées du signal,
dans lequel un premier élément actif de bobine de réception est relié à une première entrée du signal et un deuxième élément actif de bobine de réception est relié à une deuxième entrée du signal,
dans lequel le multiplexeur a un nombre d'entrées du signal, qui est plus grand que le nombre des éléments actifs de bobine de réception,
dans lequel la partie restante des plusieurs entrées du signal n'est pas reliée à un élément actif de bobine de réception,
dans lequel le multiplexeur met, pendant la réception des signaux de résonnance magnétique, en communication des entrées du signal, qui sont reliées à respectivement un élément actif de bobine de réception, les unes après les autres avec la sortie du signal, dans lequel le multiplexeur ne met pas en communication avec la sortie du signal au moins une partie de la partie restante des plusieurs entrées du signal, qui ne sont pas reliées à un élément actif de bobine de réception,
dans lequel
une bobine de corps d'ensemble incorporée dans le dispositif à résonnance magnétique comprend tous les éléments actifs de bobine de réception.

2. Procédé suivant la revendication 1,
**caractérisé**
**en ce que** le multiplexeur met en communication avec la sortie du signal en permanence l'une des entrées du signal, qui sont reliées à respectivement un élément actif de bobine de réception, de sorte que la communication n'est interrompue que par d'éventuelles brèves opérations de coupure.

3. Procédé suivant l'une des revendications 1 ou 2,
**caractérisé**
**en ce que** le multiplexeur met en communication avec la sortie du signal, de manière répétée, les entrées du signal, qui sont reliées à respectivement un élément actif de bobine de réception.

4. Procédé suivant l'une des revendications précédentes,
**caractérisé**
**en ce que** le multiplexeur met en communication avec la sortie du signal, suivant un même ordre, les entrées du signal, qui sont reliées à respectivement un élément actif de bobine de réception.

5. Procédé suivant l'une des revendications précédentes,
**caractérisé**
**en ce que** le multiplexeur met en communication avec la sortie du signal, sur des laps de temps de même longueur, les entrées du signal, qui sont reliées à respectivement un élément actif de bobine de réception.

6. Procédé suivant l'une des revendications précédentes,
**caractérisé**
**en ce que** la sortie du signal est reliée à un convertisseur analogique - numérique.

7. Procédé suivant l'une des revendications précédentes,
**caractérisé**
**en ce que** le nombre des entrées du signal est au moins de quatre.

8. Procédé suivant l'une des revendications précédentes,
**caractérisé**
**en ce que** l'on analyse, par une unité d'analyse du dispositif à résonnance magnétique, des signaux de résonnance magnétique reçus par les éléments actifs de bobine de réception.

9. Procédé suivant la revendication 8,
**caractérisé**
**en ce que**, par l'unité d'analyse, on fait la moyenne des signaux de résonnance magnétique, qui ont été reçus.

10. Dispositif à résonnance magnétique de réception de signaux de résonnance magnétique,
dans lequel le dispositif de résonnance magnétique a un premier élément actif de bobine de réception et un deuxième élément actif de bobine de réception, qui sont constitués pour recevoir des signaux de résonnance magnétique, dans lequel le dispositif à résonnance magnétique a un multiplexeur ayant une sortie du signal et plusieurs entrées du signal,
dans lequel le premier élément actif de bobine de réception est relié à une première entrée du signal et le deuxième élément actif de bobine de réception est relié à une deuxième entrée du signal, dans lequel le multiplexeur a un nombre d'entrées du signal, qui est plus grand que le nombre des éléments actifs de bobine de réception,
dans lequel la partie restante des plusieurs entrées du signal n'est pas reliée à un élément actif de bobine de réception, dans lequel le multiplexeur est constitué pour, pendant la réception des signaux de résonnance magnétique, mettre les entrées du signal, qui sont reliées respectivement à un élément actif de bobine de réception, l'une après l'autre en communication avec la sortie du signal et ne pas mettre en communication avec la sortie du signal au moins une partie de la partie restante des plusieurs entrées du signal, qui n'est pas reliée à un élément actif de bobine de réception,
dans lequel
une bobine de corps d'ensemble incorporée dans le dispositif à résonnance magnétique comprend tous les éléments actifs de bobine de réception.

11. Dispositif à résonnance magnétique suivant la revendication 10,
qui est constitué pour effectuer un procédé suivant l'une des revendications 2 à 9.

12. Produit de programme d'ordinateur, qui comprend un programme, et qui peut être chargé directement dans une mémoire d'une unité informatique programmable d'un dispositif à résonnance magnétique, comprenant des moyens de programme pour effectuer un procédé suivant l'une des revendications 1 à 9, lorsque le programme est réalisé dans l'unité informatique.
